(19) Europäisches Patentamt
European Patent Office
Office européen des brevets

(11) **EP 0 661 804 B1**

(12) **EUROPEAN PATENT SPECIFICATION**

(45) Date of publication and mention
of the grant of the patent:
**10.04.2002   Bulletin 2002/15**

(51) Int Cl.⁷: **H03G 1/00**, H03G 3/00

(21) Application number: **94309866.5**

(22) Date of filing: **28.12.1994**

(54) **Volume controller**

Lautstärkeregler

Circuit de contrôle de volume

(84) Designated Contracting States:
**DE FR GB**

(30) Priority: **28.12.1993   JP 33418393**

(43) Date of publication of application:
**05.07.1995   Bulletin 1995/27**

(73) Proprietor: **KABUSHIKI KAISHA TOSHIBA**
**Kawasaki-shi, Kanagawa-ken 210-8572 (JP)**

(72) Inventor: **Tagomori, Reiji, c/o In. Prop. Div.,**
**Toshiba Corp.**
**Tokyo (JP)**

(74) Representative:
**O'Connell, David Christopher et al**
**Haseltine Lake & Co.,**
**Imperial House,**
**15-19 Kingsway**
**London WC2B 6UD (GB)**

(56) References cited:
**EP-A- 0 146 355          EP-A- 0 548 479**
**GB-A- 2 068 186**

## Description

The present invention relates to a volume controller which is used in sound processing circuits, etc., and more particularly to a volume controller for logically controlling sound volume like a bus line sound processor IC.

Conventionally, various audio ICs have been developed by a method, such as a spectrum analysis of audio frequency. A sound volume or a tone quality of a sound source has been studied based on an audio signal transmission system, for instance, a human hearing organ or a signal transmission medium.

It is generally said that if a volume level of a sound source is attenuated by 20 dB, the sound is heard by the human hearing organ nearly at a half of the volume level. When expressed by a numerical expression, this will become a logarithmic characteristic shown by the following expression:

[Expression 1]

$$A = -20 \cdot \log_2 X$$

where, A is the hearing sensitivity and X is a sound source intensity.

A circuit conforming to this characteristic may be said to be an ideal sound volume controller.

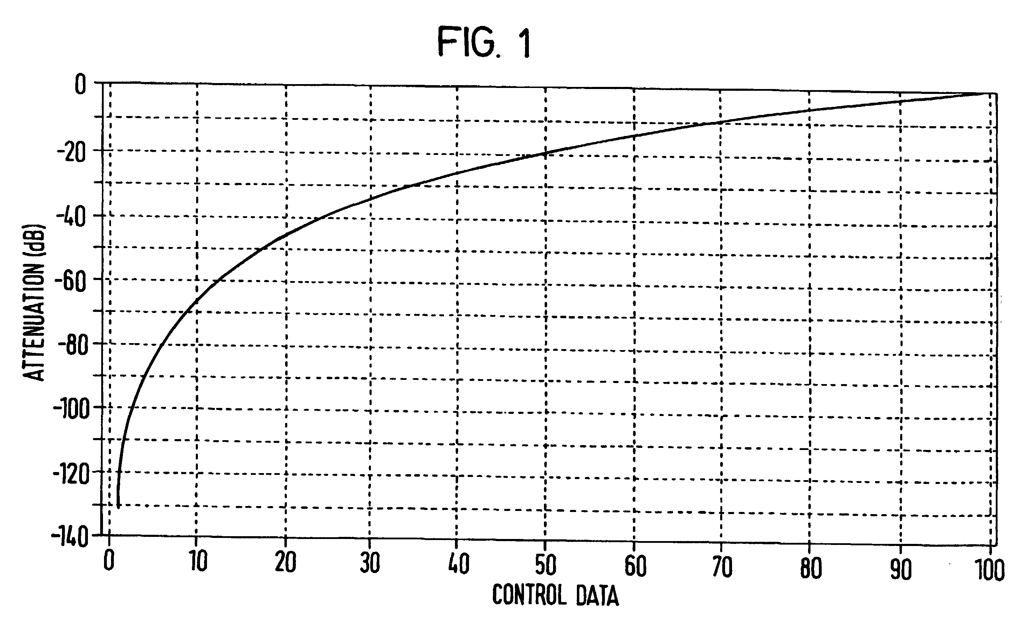

An ideal volume control curve is shown in FIGURE 1. The Y-coordinate shows volume attenuations and the X-coordinate shows gradations.

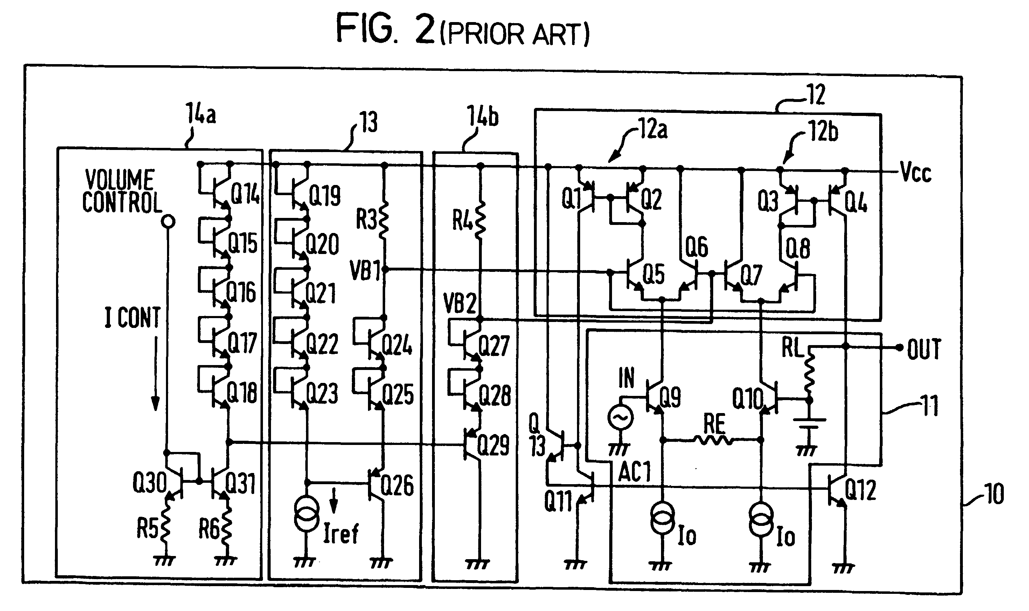

Further, a typical circuit used in a volume controller IC is shown in FIGURE 2. This circuit regulates a sound volume by setting the control current ICONT which will be explained later with reference to the drawings.

An input audio signal IN from a sound source AC1 is amplified in a differential amplifier circuit 11 which is comprised of an emitter resistor RE commonly connected to the emitters of respective transistors and a current source IO, and is output via a load resistor RL.

The collectors of transistors Q9, Q10 of the differential amplifier circuit 11 are commonly connected to a DC power source VCC via differential circuits 12a, 12b of a bias regulating circuit 12.

The differential circuits 12a, 12b for biasing are provided with two pairs of transistors Q5 - Q6 and Q7 - Q8, a DC power source VCC to be connected to the collectors of the transistors Q6 and Q7, collector-base connected cofigulation diodes Q2, Q3 to be connected to the collectors of the transistors Q5, Q8 and transistors Q1, Q4 of which bases are connected to the diodes Q2, Q3 and their emitters are connected to the DC power source Vcc.

Further, the emitters of transistors Q11, Q12 which promote the external load driving capacity are connected to a reference potential and their bases are connected to tho emitter of a transistor Q13. The base of the transistor Q13 is connected to the collector of the transistor Q11 and the collector of the transistor Q13 is connected to the DC power source Vcc.

The bases of the transistors Q5 - Q8 in the differential circuit 12 are connected to a reference current circuit 13 for providing a reference current (Iref) and control current. setting circuits 14A, 14B which are set by the control current ICONT, respectively, and base potentials VB1, VB2 are set by the reference current Iref and the control current ICONT.

The reference current circuit 13 is provided with collector-base connected diodes Q19 - Q23 that are connected to the DC power source VCC and the reference current source Iref and is comprised of a transistor Q26 whose has the base connected to the reference current source Iref and the emitter connected to the reference potential source, collector-base connected two-stage connecting diodes Q24, Q25, a resistor R3 and the DC power source VCC. An emitter voltage of the transistor Q26 of the reference current circuit 13 is supplied to the base of the transistor Q5 of the differential circuit 12a of the bias regulating circuit 12 and the base of the transistor Q8 of the other differential circuit 12b via the diodes Q24, Q25.

Likewise the reference current circuit 13, the control current setting circuit 14a is provided with a constant current source comprising a transistor Q31 and five stack-connected diodes Q14 - Q18. The base current of the transistor Q31 is controlled by the control current ICONT, while the emitter voltage of the transistor Q31 regulates a voltage VB2 which will be described later. Further, the control current setting circuit 14b is comprised of two stack-connected diodes Q27, Q28, a transistor Q29 and a resistor R4, which are connected in series. The connection node of the diode Q27 and the resistor R4 is connected to the bases of the transistors Q6, Q7 of the differential circuits 12a, 12b.

A volume control circuit 10 attenuates the weighted sound volume by approx. 20 dB when the volume level is suppressed from the maximum level to the medium level. If the volume is further suppressed lower than the medium level, the volume control circuit 10 sharply attenuates the weighted sound volume.

This is because if the attenuation is insufficient, the sound is heard as a residual sound. In order to eliminate this residual sound, the two series of the collector-base connected configuration diodes Q14 - Q18 and Q19 - Q23 are each stacked in five layers.

Hereinafter, potential relations of PN junction systems will be explained in detail using an electronic physical properties.

It is assumed that collector current of a bipolar transistor is IC, saturated current of PN junction in the reverse direction is IS, coefficient of heat of molecular motion: Boltzmann's constant is K, absolute temperature expressed by Kelvin temperature is T and electronic charge is q. Voltages between collector, base and emitter are expressed by adding a subscript of C for collector. B for base and E for emitter, and VBE, for instance, denotes the base to emitter potential. Further, a current value of the reference current source is denoted as Iref and also the control current is denoted as ICONT. In addition, the emitter to collector current amplification factor of a bipolar transistor is &A.

If input voltages of the differential circuits 12a, 12b are VB1, VB2 (see FIGURE 2), a following relationships are established.

## [Expression 2]

$$VB1 \;=\; V_\alpha - 5 \times V_{BE} + 3 \times V_{BE}$$

$$=\; V_\alpha - 5 \times h \times \ln\left(\frac{I_{ref}}{I_S}\right) + 3 \times V_{BE}$$

$$VB2 \;=\; V_\alpha - 5 \times V_{BE} + 3 \times V_{BE}$$

$$=\; V_\alpha - 5 \times h \times \ln\left(\frac{I_{cont}}{I_S}\right) + 3 \times V_{BE}$$

where

$$h = \frac{kT}{q}$$

When a difference is calculated according to the above expression.

[Numerical Expression 3]

$$\frac{\Delta V_B}{h} = \ln\left(\frac{I_{ref}}{I_{cont}}\right)^5$$

Further, when the current characteristic of the PN junction system is expressed by an exponential function as follows.

## [Expression 4]

$$I_E = I_S\left(\exp\left(\frac{V_{BE}}{h}\right) - 1\right) = I_0$$

then a following expression is calculated:

**[Expression 5]**

$$I_c = \frac{\alpha \cdot I_0}{1 + \exp\left(\dfrac{\Delta V_B}{h}\right)} = \frac{\alpha \cdot I_0}{1 + \left(\dfrac{I_{ref}}{I_{cont}}\right)^5}$$

The DC voltage and the collector output signal are fed back to the base of the transistor Q10 of the differential amplifier circuit 11 via the load resistor RL. The amplification gain of the audio signal is calculated according to the emitter resistor RB, the load resistor RL, the emitter current, i.e., the ratio of the current source I0 and the collector current IC given by the above equation 5. The gain expression converted into the decibel unit is shown as follows:

**[Expression 6]**

$$\text{Gain} = 20 \cdot \log\left(\frac{V_{out}}{V_{in}}\right) = 20 \cdot \log\left(\frac{I_C}{I_0} \cdot \frac{R_L}{R_E}\right) \qquad \cdots \cdots \qquad 1$$

From the above expression, it can be seen that Iref/Icont = 1.55 is sufficient for achieving an attenuation of 20 dB.

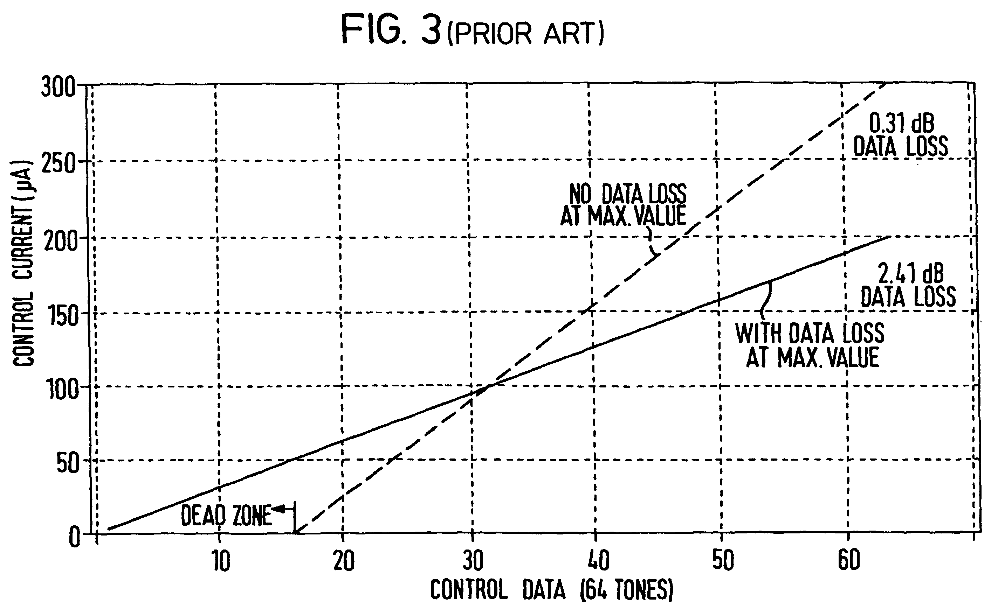

However, if the attenuation characteristic is set using Iref/Icont = 1.55 as an intermediate value as shown in FIGURE 3, the control current ICONT changes linearly. Therefore, minimum and maximum values are decided uniquely. Thus the maximum current ratio will become 0.775, while the amount of the attenuation will become 2.14 dB.

As shown by the dotted line in FIGURE 3, if the control current is so set that the control current value will reach the maximum value at three times of the intermediate value by changing the attenuation characteristic, the attenuation is improved to 0.31 dB at the maximum value. However there is such a problem that as a setting of the minimum value does not correspond to the characteristics of the minimum volume level it falls in outside the operation range so as to cause the dead zone to extend up to near the intermediate value.

Further, as a measure for improving this problem, a method is considered to increase the gain by making the load resistor RL larger. However, when considering a thermal noise of resistors, an impedance mismatch or a noise characteristic of feedback paths, the above method also has such a problem that the load resistor RL causes a deterioration of the noise characteristic and worses the residual noise.

In addition, an amount of a DC offset componont, i.e., an error component of input and output signals is increased by a Load resistance value. Therefore, an increase of this value will become disadvantageous for the operating characteristic.

Further, if the emitter resistance RE is decreased, it causes not only the decrease of the minimum input sensitivity, but also the lowering of the input dynamic range. Therefore, the bias current must be set larger. However, this will result in such problems as increase in current consumption and worsening of DC offset.

After all, in the improvements of attenuation rate by using the load resistor RL and the emitter resistor RE, there are still such problems that not much improvement is obtainable. As to the noise level at the maximum volume value, it becomes rather worse with increasing its loss. It is also impossible to improve the gain in the state that the maximum volume is set, without deteriorating circuit characteristics, when the control current has a linear characteristic.

As described above, in the prior art circuit, as a sound volume is varied by linearly changing the control current, there is a problem that it is impossible to simultaneously improve such operating characteristics as a reduction of the gain loss at the setting of the maximum volume, an expansion of the input dynamic range, a noise reduction, etc.

GB-A-2068186 describes a digitally programmable transconductance amplifier, including two digital-analog converters. Based on a digital input signal, the digital-analog converters are used to weight an analog signal to produce a controllable output current.

The present invention seeks to provide a volume controller which, in preferred embodiments, perform a compensation of the shortage of control current at a maximum volume level, a suppression of the gain loss, and an expansion of the dynamic range.

According to the present invention, there is provided a volume controller comprising: a volume regulating circuit (10) having an input terminal (IN) connected to an audio signal source (AC1) and a control terminal to which a volume regulating voltage is supplied; **characterised in that** the volume controller further comprises: means for supplying parallel data in multiple bits; a D/A conversion circuit (20), having multiple current circuits (22-27) formed in parallel, corresponding to each bit of the parallel data, the ON/OFF state of each of said current circuits corresponding to the value of the respective bit of the parallel data, the conversion circuit (20) supplying the total sum current flowing through said current circuits; control means (30) for controlling said sum current in a non-linear manner by switching the levels of the currents supplied by current sources ($I_2$ - $I_7$) of the respective current circuits (22-27) as a function of the most significant bit of the parallel data; and means for generating the volume regulating voltage by converting the total sum current level into a voltage level.

Thus, advantageously, it is possible to carry out a suppression of the gain loss at the maximum volume level, and to expand the input dynamic range from the minimum volume level to the maximum volume level by appropriately setting a reference current in a D/A converter by controlling the reference current using a controller.

Additional objects and advantages of the present invention will be apparent to persons skilled in the art from a study of the following description and the accompanying drawings, which are hereby incorporated in and constitute a part of this specification.

For a better understandings of the present invention and many of the attendant advantages thereof, reference will now be made by way of example to the accompanying drawings, wherein:

FIGURE 1 is a diagram showing an ideal volume control characteristic;
FIGURE 2 is a circuit diagram showing a conventional volume controller;
FIGURE 3 is a diagram showing the control current characteristic of a conventional volume controller;
FIGURE 4 is a circuit diagram showing one embodiment of the volume controller according to the present invention;
FIGURE 5 is a diagram for explaining the operation of the D/A converter shown in FIGURE 4;
FIGURE 6 is a diagram showing the control current characteristic of the volume controllor shown in FIGURE 4;
FIGURE 7 is a diagram showing the volume characteristic of the volume controller shown in FIGURE 4;
FIGURE 8 is a circuit diagram showing another embodiment of the volume controller according to the present invention;
FIGURE 9 is a diagram showing the volume characteristic of the volume controller shown in FIGURE 8;
FIGURE 10 is a circuit diagram showing another embodiment of the volume controller according to the present invention; and
FIGURE 11 is a diagram showing the volume level characteristic of the volume controller shown in FIGURE 10.

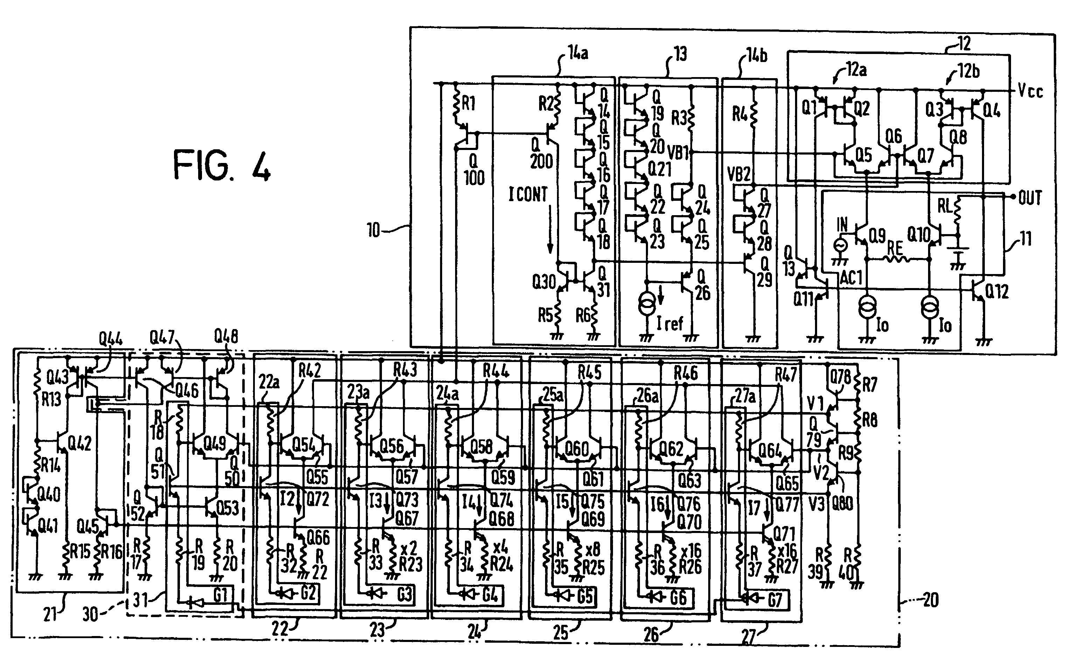

The present invention will be described in detail with reference to the FIGURES 4 through 11.

FIGURE 4 is a preferred embodiment of a volume control circuit according to the present invention. The same or similar elements as those in FIGURE 2 will be assigned the same reference numerals and explained with the reference numerals.

In FIGURE 4, a volume control circuit is provided with a volume control circuit 10, a D/A converter 20 and a nonlinear controller 30 for controlling a control current with a nonlinear characteristic.

The volume control circuit 10 is in the same structure as a conventional volume control circuit and control current is controlled by the nonlinear controller 30.

The nonlinear controller 30 is comprised of a constant current source and a switching circuit 31. The constant current circuit is comprised of a differential circuit provided with a pair of transistors Q49, Q50, a DC power source VCC, transistors Q46, Q52, Q53 comprising a constant current source, resistors R17, R20, a transistor Q48 configured in a collector-base connected diode fashion, which is connected to the collector of the transistor Q50 of the differential circuit, and a transistor Q47 having the base connected to the base of the transistor Q48 and the collector connected to a reference current circuit 21.

The switching circuit 31 is connected to the base of a transistor Q49 of the differential circuit Q49/Q50, while a DC power source V2 is oonneoted to the base of the other transistor Q50 of the differential circuit Q49/Q50.

The switching circuit 31 is comprised of another DC power source V1, a resistor R18, a switching transistor Q51, a resistor R19 and a gate circuit G1. The DC power source V1 is connected to the collector of the switching resistor Q51 via the resistor R18. The emitter of the transistor Q51 is then connected to a gate circuit G1, for instance, an open collector type inverter circuit via the resistor R19. The base of the switching circuit Q51 is connected to another DC power source V3.

The switching circuit 31 is provided for receiving a data on a most significant bit (hereinafter referred to as MSB) of a parallel data bus.

The reference current circuit 21 is comprised of a reference current source I1, a diode-fashion transistor Q45 and a resistor R16. Further the reference current source I1 is comprised of a bias setting circuit and a transistor Q44.

The bias setting circuit is provided with a diode-fashion transistor Q43 connected to the base of the transistor Q44, an emitter-grounded transistor Q42, and a bias circuit for the transistor Q42 which is comprised of resistors R13, R14 and diode-fashion transistors Q40, Q41.

Further, the D/A converter 20 is provided with the nonlinear controller 30, the reference current circuit 21, constant current circuits 22 - 27 and the DC power source VCC. The constant current circuits 22 - 27 are then provided for every bit of the parallel data bus. The whole of the constant current circuits 22 - 27 in the parallel data bus provide the control current ICONT. Further the control current value ICONT can be set for every constant current value of a least significant bit (hereinafter referred to as LSB). The constant current circuit 22 corresponds to the LSB, while the constant current circuit 27 corresponds to the MSB. The constant current circuits 22 - 27 include constant current sources I2 - I7, respectively, which are comprised of transistors Q45 - 65 coupled in five sets of differential circuits, switching circuits 22a - 27a, resistors R22 - R27 and transistors Q66 - Q71.

Starting from the constant current source I2, currents with two times value are sequentially set in the constant current sources I2 - I7, thus for example a current with 16 times value is set for the constant current source I6.

The constant current circuits 22 - 27 for respective bits are connected to the DC power source VCC via a diode-fashion transistor Q100 and the resistor R1 in order to control the control current setting current value ICONT of the volume circuit 10.

The diode-fashion transistor Q100 is connected to the base of a transistor Q200 of the control current setting circuit 14a. Thus the control current ICONT flows from the DC power source VCC via the emitter-collector path of the transistor Q200 in response to the change in the current from the D/A converter 20. The control current ICONT sets the base voltage VB2 on the bases of the transistors Q6 and Q7 in the adjacent differential circuits Q5/Q and Q7/Q8 in the bias setting circuit 12 connected to the collectors of the transistors Q9, Q10 of the differential amplifier circuit 11.

Referring now to FIGURES 2 and 4, the operation of the volume control circuit of FIGURE 4 will be explained.

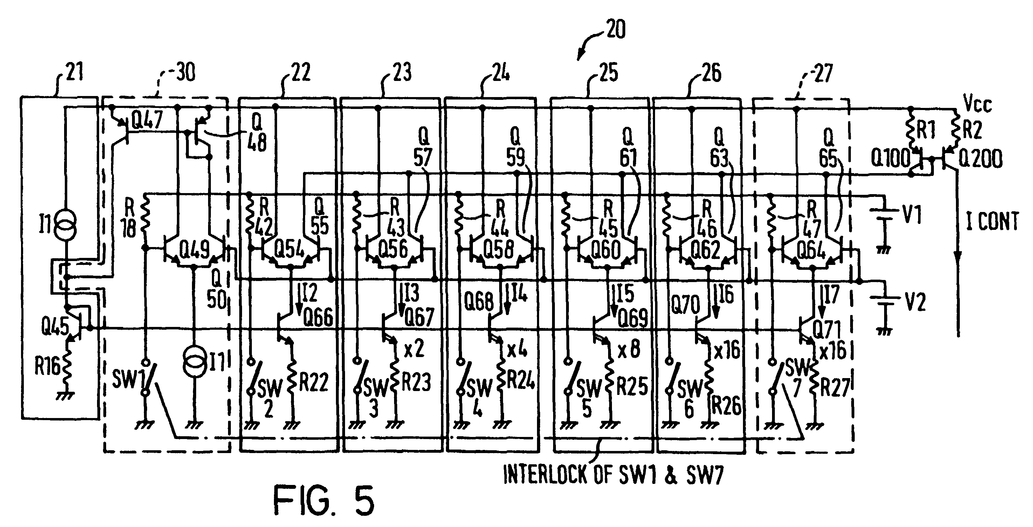

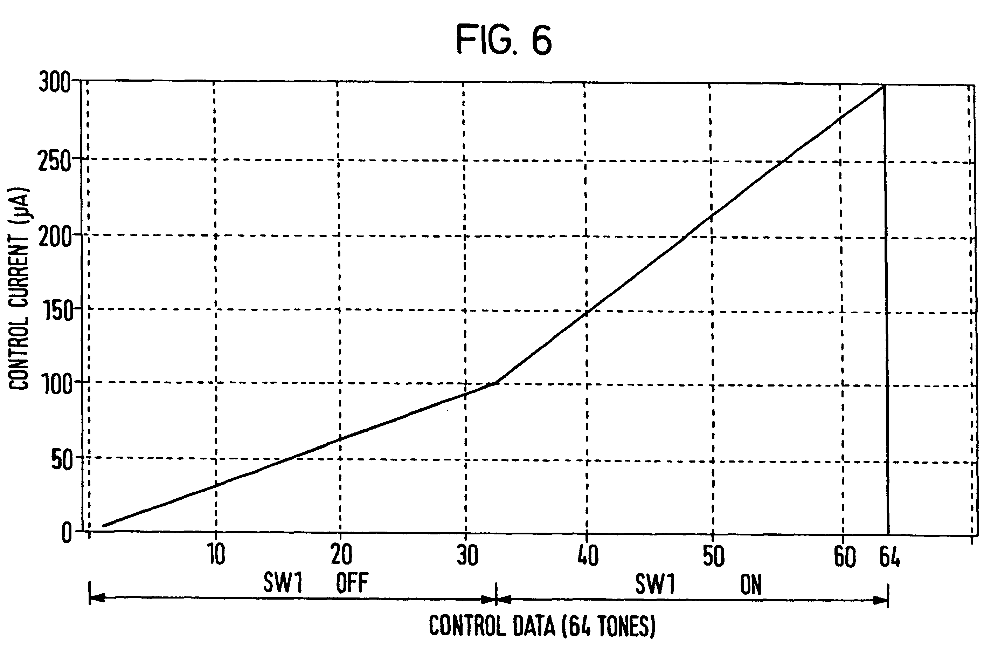

FIGURE 5 is an explanatory diagram illustrating the operation of the D/A converter of the volume control circuit shown in FIGURE 4. FIGURE 6 is a graph showing the control current characteristic of the circuit shown in FIGURE 5.

In FIGURE 5, the current sources in the reference current circuit 21 and the nonlinear controller 30 are shown by I2 - I7 and I1, but the same currents flow therethrough. The switching circuit 31 in the nonlinear controller 30 and the switching circuits 22a - 27a in the constant current circuits 22 - 27 are shown by the switches SW1 - SW7, respectively. The ON/OFF states of the switches SW1 - SW7 are controlled by parallel bit data. The LSB data out of a G-bit data is supplied to the switch SW2, while the other bit data higher than the LSB data are sequentially supplied to the switches SW3 - SW6. Thus the MSB data is supplied to the switch SW7.

The switches SW1 - SW7 are turned ON when the supplied data thereto is "1", or turned OFF when the supplied data is "0". Further, it is so provided that the values of the constant current sources I2, I3, ... I6 sequentially increase by two times in the order.

In FIGURE 5, if the bit data supplied to the switches SW1 - SW7 are all "0", the switches SW1 - SW7 are turned OFF so that the transistors Q49, Q54, Q58, Q60, Q62 and Q64 are turned ON. While in that state as the transistors Q50, Q55, Q57, Q59, Q61, Q63 and Q65 being left in the OFF state, any currents fail to flow through the transistor Q100. Accordingly the control current is set in zoro current. Further, when only the least significant bit (LSB) is "1", only the switch SW2 in the constant current circuit 22 ie turned ON. As a result a current equal to the current I2 flows through the transistor Q100.

In the same manner, the constant current I3 - I6 flow through the transistor Q100, in response to the bit data applied thereto. That is, the total amount of the currents I3 - I6 flows through the transistor Q100.

Further, when the most significant bit (MSB) becomes "1", the switches SW1 and SW7 are turned ON. Then the transistor Q49 is turned OFF but the transistor Q50 is turned ON. Thus a current flows through the transistor Q45 based on the current-mirror connection due to the current mirrors Q48, Q47 between the transistor Q45 and Q50. The current of the transistor Q45 is given by the sum of the constant current I1 and the current flowing through the transistor Q47. Accordingly, the current becomes twice the amount of the constant current I1. Then, currents flowing through the transistors Q66, Q67, Q68, Q69, Q70 and Q71 which constitute similar current-mirrors, respectively, in connection with the transistor Q45, become also twice the constant current I1. When the MSB becomes "1" (the medium point of 64 tones), the current flowing through the transistor Q100 so increases that the control current ICONT having such a characteristic as shown in FIGURE 6 is obtained.

The current in the reference current source Iref becomes 100 µA and thus the minimum current set value of the D/A converter (i.e., the resolution of the D/A converter 20) will become a value obtained by dividing the reference current with the number of data, that is, a value given by $100 \div 32 = 3.125$ µA. On the other hand, when the switch SW1 is ON, that is, the MSB is high, the reference current becomes 200 µA, a sum with the current value 100 µA of the constant current circuit and the minimum current set value of the D/A converter 20 will become the value given by

$200 \div 32 = 6.25$ µA. Thus, it becomes possible to obtain the control current characteristic, as shown in FIGURE 6, by turning OFF the switch SW1 for the narrow volume range and turning ON the switch SW1 for the volume range from the medium volume to the maximum volume.

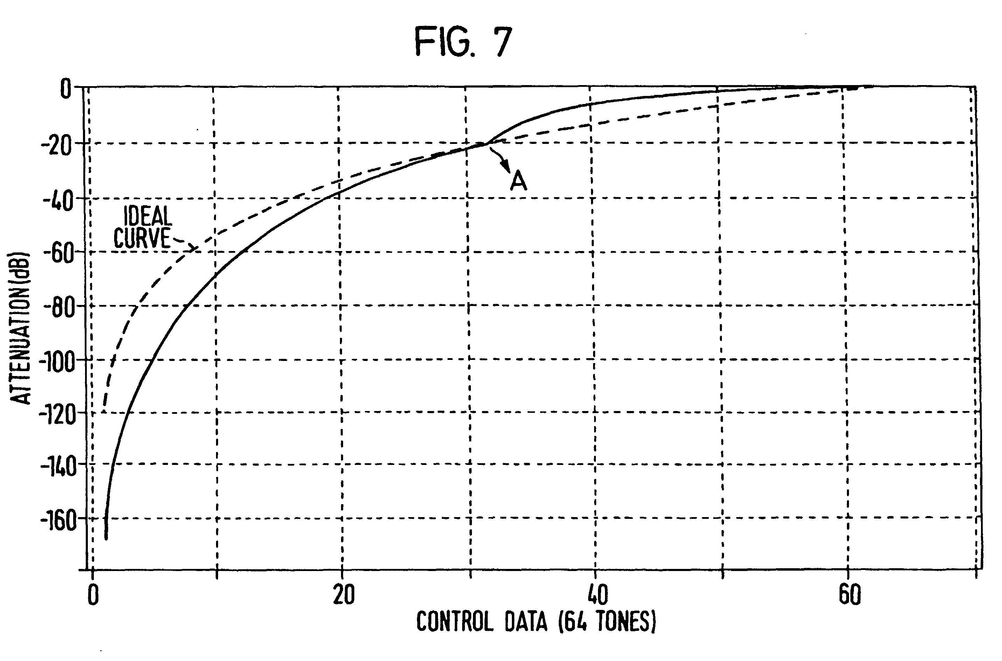

Further, an exemplified volume characteristic, as shown in FIGURE 7, is also obtained. An attenuation of 20 dB is achieved at a point around the medium section. At the maximum volume it becomes possible to flow a current of 300 µA determined by the total sum of all bits. Thus the gain loss at the maximum volume can be reduced. The dotted line in the graph plots an ideal volume characteristic curve and the solid line plots a volume characteristic curve of the embodiment of the volume control circuit according to the present invention. Point A indicates the changing point of the ON and OFF areas of the switch SW1.

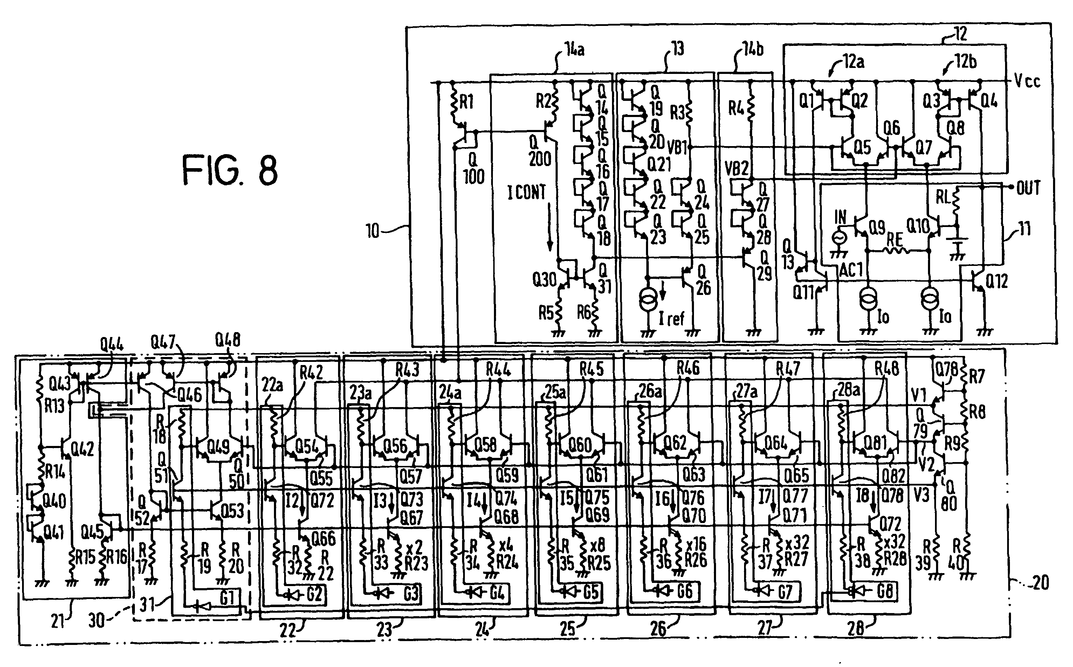

FIGURE 8 shows another preferred embodiment of the present invention. This is an example of data modified from the 6-bit data to a 7-bit data. Except that a circuit for one bit is added, this embodiment is entirely the same as the embodiment as already described above. That is, a constant current circuit 28 (including transistors Q78, Q81 and Q82) associated with the MSB of the 7-bit data is newly added.

According to the above arrangement, it becomes possible to increase data and thus possible to increase a current value at the maximum volume level. Thus the gain loss is further decreased.

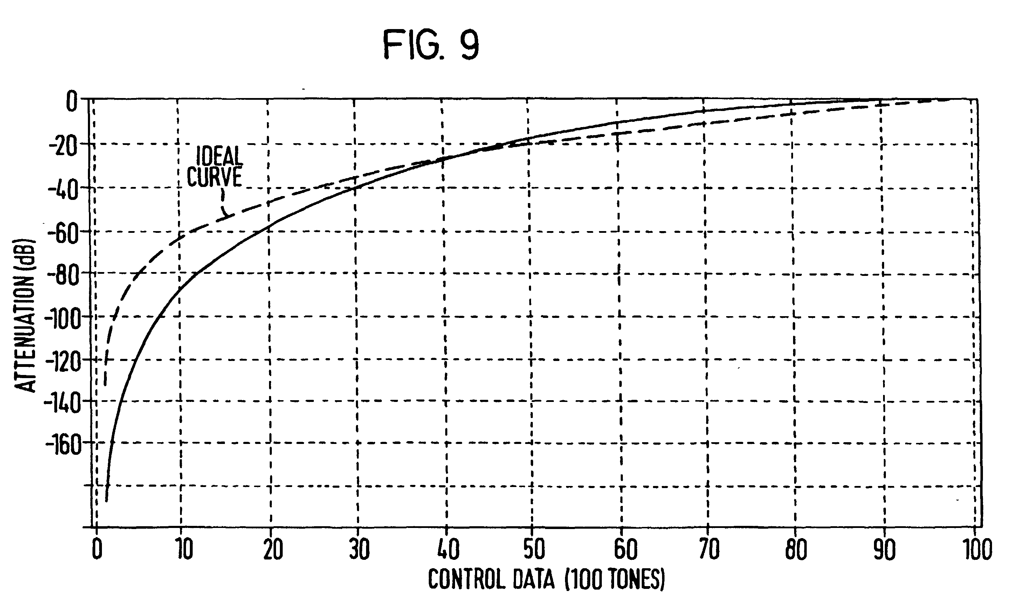

FIGURE 9 shows a graph illustrating the volume control characteristic of the second embodiment of FIGURE 8. This graph shows an example using 100 tones; 7-bit data allow up to 128 tones. The dotted line in the graph shows an ideal level characteristic, while the solid line is the volume characteristic of the volume controller shown in Figure 8.

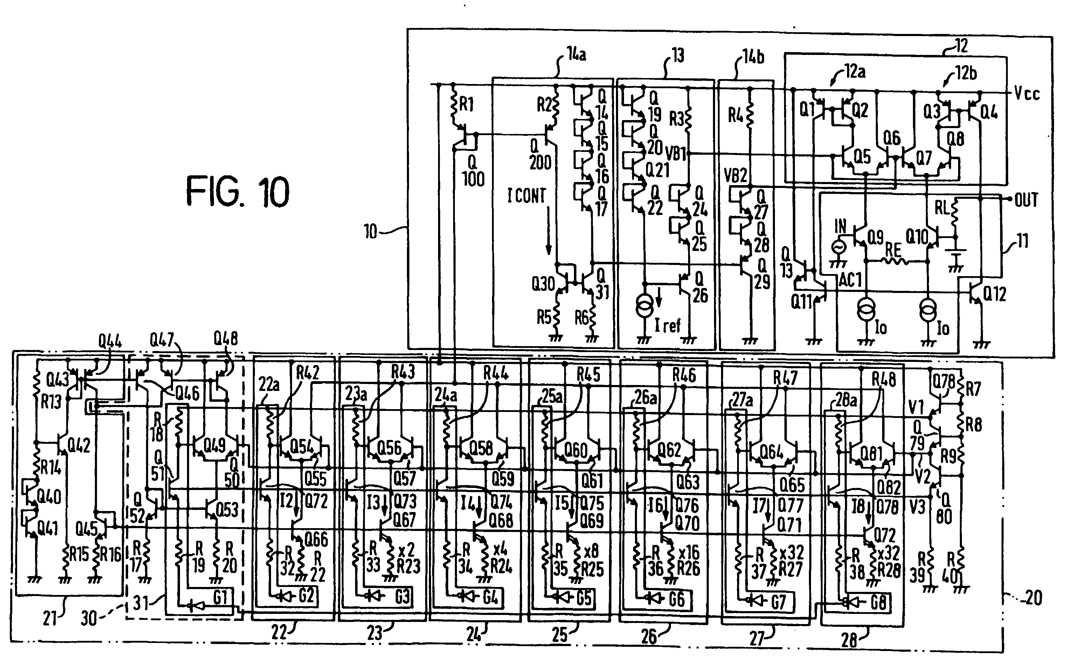

Figure 10 shows a third embodiment of the volume controller according to the present invention, in which two series of four stack-connected diodes Q14-Q17, Q19-Q22 are used in place of the two series of five stack-connected diodes Q14-Q18, Q19-Q23.

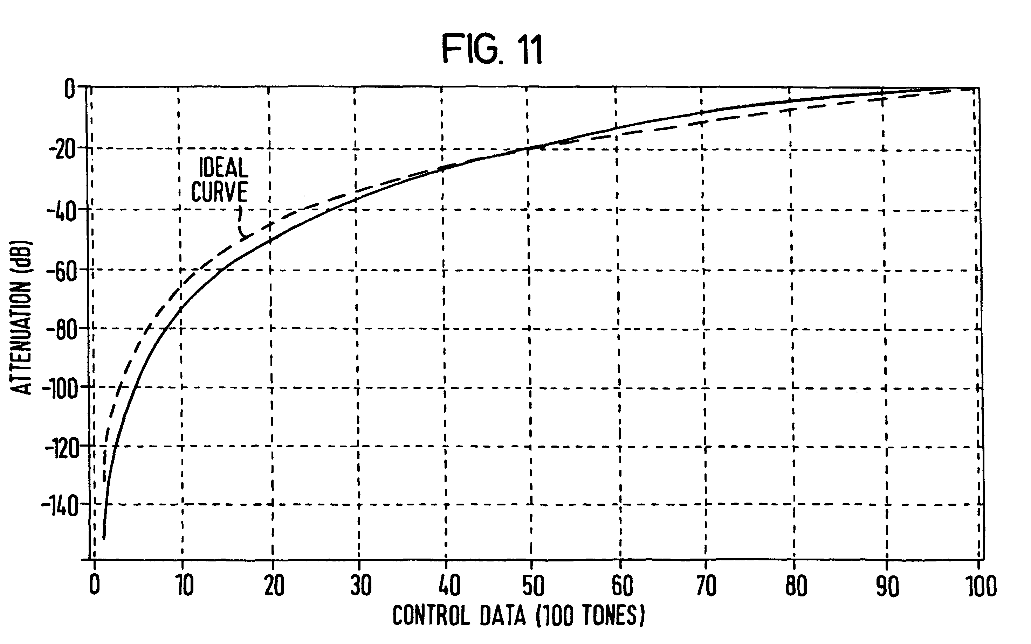

Figure 11 shows the volume level characteristic of the volume controller of Figure 10, showing the improved characteristic in the low volume region.

The present invention therefore provides a volume controller having desirable properties.

While preferred embodiments of the invention have been described with reference to the drawings, it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefor, it is intended that the present invention not be limited to the particular embodiment disclosed as the best mode contemplated for carrying out the present invention, but that the present invention includes all embodiments falling within the scope of the appended claims.

**Claims**

1.  A volume controller comprising:

    a volume regulating circuit (10) having an input terminal (IN) connected to an audio signal source (AC1) and a control terminal to which a volume regulating voltage is supplied;

    **characterised in that**
    the volume controller further comprises:

    means for supplying parallel data in multiple bits;
    a D/A conversion circuit (20), having multiple current circuits (22-27) formed in parallel, corresponding to each bit of the parallel data, the ON/OFF state of each of said current circuits corresponding to the value of the respective bit of the parallel data, the conversion circuit (20) supplying the total sum current flowing through said current circuits;
    control means (30) for controlling said sum current in a non-linear manner by switching the levels of the currents supplied by current sources ($I_2$ - $I_7$) of the respective current circuits (22-27) as a function of the most significant bit of the parallel data; and
    means for generating the volume regulating voltage by converting the total sum current level into a voltage level.

2.  A volume controller as claimed in claim 1, wherein each of the current circuits of the D/A conversion circuit includes:

    a respective first differential circuit, comprising a first and a second transistor (Q54-Q55, Q56-Q57, Q58-Q59, Q60-Q61, Q62-Q63, Q64-Q65) commonly connected by their emitters;

a first constant current source ($I_2$, $I_3$, $I_4$, $I_5$, $I_6$, $I_7$) connected to the emitters of the first and the second transistors;

the base bias source (V1, V2) for the first and the second transistors, and

means ($SW_2$, $SW_3$, $SW_4$, $SW_5$, $SW_6$, $SW_7$) for switching the ON/OFF state of the first and the second transistors by controlling the base voltage of the first transistor (Q54, Q56, Q58, Q60, Q62, Q64) as a function of the parallel data;

the collectors of the first transistors of the current circuits being connected to a DC voltage source ($V_{CC}$) and the collectors of the second transistors (Q55, Q57, Q59, Q61, Q63, Q65) being connected with each other, to obtain said sum current.

3. A volume controller as claimed in claim 1, wherein the control means (30) includes:

a differential circuit comprising a third and a fourth transistor (Q49, Q50) commonly connected by their emitters;

a second constant current source (I1) connected to the emitters of the third and the fourth transistors;

the base bias source (V1, V2) for the third and the fourth transistors;

means ($SW_1$) for switching the ON/OFF state of the third and the fourth transistors by controlling the base voltage of the third transistor (Q49) as a function of the most significant bit of the parallel data;

a first current mirror circuit (Q47, Q48) connecting the input terminal to the collector of the fourth transistor (Q50), and

a second current mirror circuit (Q43, Q44) to which the output current of the first current mirror circuit (Q47, Q48) and the current from a third constant current source (I1) is supplied as input current;

the current amount supplied by the current sources ($I_2$ - $I_7$) of the respective current circuits (22-27) being determined as a function of the output current of the second current mirror circuit.

4. A volume controller as claimed in claim 1, wherein the D/A conversion circuit includes the parallel data supply means, further **characterised in that**:

by switching the levels of the currents supplied by the current sources as a function of the most significant bit of the parallel data, the control means causes the D/A conversion circuit to have a characteristic which is non-linear as between a first and a second region of a range of values of the parallel data.

**Patentansprüche**

1. Lautstärkeregler, umfassend:

eine Lautstärke-Regelschaltung (10), die einen Eingangsanschluss (IN) aufweist, der mit einer Audiosignalquelle (ACI) verbunden ist, und einen Regelanschluss, an den eine Lautstärke-Regelspannung angelegt wird,

**dadurch gekennzeichnet, dass** der Lautstärkeregler zudem umfasst:

eine Vorrichtung, die parallele Daten mit mehreren Bits liefert;

eine D/A-Umsetzschaltung (20), die zahlreiche parallel ausgebildete Stromschaltungen (22 - 27) aufweist, die jeweils einem Bit der parallelen Daten entsprechen, wobei der Ein/Aus-Zustand einer jeden Stromschaltung dem Wert des entsprechenden Bits der parallelen Daten entspricht, und die Umsetzschaltung (20) den Gesamtsummenstrom liefert, der durch die Stromschaltungen fließt;

eine Regelvorrichtung (30), die den Summenstrom in nichtlinearer Weise regelt, indem sie die Pegel der Ströme, die die Stromquellen ($I_2$ - $I_7$) der jeweiligen Stromschaltungen (22 - 27) liefern, abhängig vom höchstwertigen Bit der parallelen Daten schaltet; und

eine Vorrichtung, die eine Lautstärke-Regelspannung erzeugt, indem sie den Gesamtsummenstrom auf einen Spannungspegel umsetzt.

2. Lautstärkeregler nach Anspruch 1, wobei jede Stromschaltung der D/A-Umsetzschaltung enthält:

eine entsprechende erste Differenzschaltung, die einen ersten und einen zweiten Transistor (Q54 - Q55, Q56 - Q57, Q58 - Q59, Q60 - Q61, Q62 - Q63, Q64 - Q65) enthält, die über ihre Emitter miteinander verbunden sind;

eine erste Konstantstromquelle ($I_2$, $I_3$, $I_4$, $I_5$, $I_6$, $I_7$), die mit den Emittern des ersten und des zweiten Transistors verbunden ist;

die Basisvorbelastungsquelle (V1, V2) für den ersten und zweiten Transistor, und

Vorrichtungen (SW$_2$, SW$_3$, SW$_4$, SW$_5$, SW$_6$, SW$_7$), die den Ein/Aus-Zustand der ersten und zweiten Transistoren umschalten, indem sie die Basisspannung des ersten Transistors (Q54, Q56, Q58, Q60, Q62, Q64) abhängig von den parallelen Daten regeln, wobei

die Kollektoren der ersten Transistoren der Stromschaltungen mit einer Gleichspannungsquelle (V$_{cc}$) verbunden sind und die Kollektoren der zweiten Transistoren (Q55, Q57, Q59, Q61, Q63, Q65) miteinander verbunden sind, damit man den Summenstrom erhält.

**3.** Lautstärkeregler nach Anspruch 1, wobei die Regelvorrichtung (30) enthält:

eine Differenzschaltung, die einen dritten und einen vierten Transistor (Q49, Q50) umfasst, die an ihren Emittern miteinander verbunden sind;

eine zweite Konstantstromquelle (I1), die mit den Emittern des dritten und des vierten Transistors verbunden ist;

die Basisvorbelastungsquelle (V1, V2) für den dritten und vierten Transistor;

eine Vorrichtung (SW$_1$), die den Ein/Aus-Zustand des dritten und des vierten Transistors umschaltet, indem sie die Basisspannung des dritten Transistors (Q49) abhängig vom höchstwertigen Bit der parallelen Daten regelt;

eine erste Stromspiegelschaltung (Q47, Q48), die den Eingangsanschluss mit dem Kollektor des vierten Transistors (Q50) verbindet, und

eine zweite Stromspiegelschaltung (Q43, Q44), der der Ausgangsstrom der ersten Stromspiegelschaltung (Q47, Q48) und der Strom aus einer dritten Konstantstromquelle (I1) als Eingangsstrom zugefthrt wird,

wobei die Strommenge, die die Stromquellen (I$_2$ - I$_7$) der entsprechenden Stromschaltungen (22 - 27) abgeben, abhängig vom Ausgangsstrom der zweiten Stromspiegelschal. tung bestimmt ist.

**4.** Lautstärkeregler nach Anspruch 1, wobei die D/A-Umsetzschaltung die parallele Datenzufuhrvorrichtung enthält und zudem **dadurch gekennzeichnet ist,**

**dass** durch das Umschalten der Pegel der Ströme, die die Stromquellen abhängig vom höchstwertigen Bit der parallelen Daten zuführen, die Regelvorrichtung die D/A-Umsetzschaltung veranlasst, eine Charakteristik zu haben, die zwischen einer ersten und einer zweiten Region eines Wertebereichs. der parallelen Daten nichtlinear ist.

## Revendications

**1.** Un dispositif de commande de volume comprenant :

un circuit de régulation de volume (10) présentant une borne d'entrée (IN) reliée à une source de signal audio (AC1) et une borne de commande à laquelle est appliquée une tension de régulation de volume ;

**caractérisé en ce que**
le dispositif de commande de volume comprend en outre :

des moyens pour fournir des données parallèles en de multiples bits ;

un circuit de conversion N/A (20), présentant de multiples circuits de courant (22 à 27) formés en parallèle, correspondant à chaque bits des données parallèles, l'état passant/non passant de chacun desdits circuits de courant correspondant à la valeur du bit respectif des données parallèles, le circuit de conversion (20) fournissant l'ensemble du courant somme passant à travers lesdits circuits de courant ;

des moyens de commande (30) pour commander ledit courant somme d'une manière non linéaire en commutant les niveaux des courants fournis par les source de courant (I$_2$ - I$_7$) des circuits de courant respectifs (22 à 27) en fonction du bit le plus significatif des données parallèles ; et

des moyens pour produire la tension de régulation de volume en convertissant le niveau de l'ensemble des courants somme en un niveau de tension.

**2.** Un dispositif de commande de volume tel que revendiqué à la revendication 1, dans lequel chacun des circuits de courant du circuit de conversion N/A comprend :

un premier circuit différentiel respectif, comportant un premier et un second transistor (Q54-Q55, Q56-Q57, Q58-Q59, Q60-Q61, Q62-Q63, Q64-Q65) reliés en commun par leurs émetteurs ;
une première source de courant constant ($I_2$, $I_3$, $I_4$, $I_5$, $I_6$, $I_7$) reliée aux émetteurs du premier et du second transistor ;
la source de polarisation de base (V1, V2) pour le premier et le second transistor, et
des moyens ($SW_2$, $SW_3$, $SW_4$, $SW_5$, $SW_6$, $SW_7$) pour commuter l'état passant/non passant du premier et du second transistor en commandant la tension de base du premier transistor (Q54, Q56, Q58, Q60, Q62, Q64) en fonction des données parallèles ;
les collecteurs des premiers transistors des circuits de courant étant reliés à une source de tension de courant continu ($V_{CC}$) et les collecteurs des second transistors (Q55, Q57, Q59, Q61, Q63, Q65) étant reliés l'un à l'autre pour obtenir ledit courant somme.

3. Un dispositif de commande de volume tel que revendiqué à la revendication 1, dans lequel les moyens de commande (30) comporte :

un circuit différentiel comportant un troisième et un quatrième transistor (Q49, Q50) reliés en commun par leurs émetteurs ;
une seconde source de courant constant (I1) reliée aux émetteurs du troisième et du quatrième transistor ;
la source de polarisation de base (V1, V2) pour le troisième et le quatrième transistor ;
des moyens ($SW_1$), pour commuter l'état passant/non passant du troisième et du quatrième transistor en commandant la tension de base du troisième transistor (Q49) en fonction du bit le plus significatif des données parallèles ;
un premier circuit de courant symétrique (Q47, Q48) reliant la borne d'entré au collecteur du quatrième transistor (Q50), et
un second circuit de courant symétrique (Q43, Q44) auquel le courant de sortie du premier circuit de courant symétrique (Q47, Q48) et le courant d'une troisième source de courant constant (I1) sont appliqués en tant que courant d'entrée ;
la quantité de courant fournie par les sources de courant ($I_2$ à $I_7$) des circuits de courant respectifs (22 à 27) étant déterminée en fonction du courant de sortie du second circuit de courant symétrique.

4. Un dispositif de commande de volume tel que revendiqué à la revendication 1, dans lequel le circuit de conversion N/A comprend les moyens d'alimentation de données parallèles, **caractérisé en outre en ce que** :

en commutant les niveaux des courants fournis par les sources de courant en fonction du bit le plus significatif des données parallèles, les moyens de commande amènent le circuit de conversion N/A à avoir une caractéristique qui est non linéaire entre une première et une seconde zone d'une gamme de valeurs des données parallèles.

## FIG. 1

CONTROL DATA

ATTENUATION (dB)

FIG. 2 (PRIOR ART)

FIG. 3 (PRIOR ART)

EP 0 661 804 B1

FIG. 4

EP 0 661 804 B1

FIG. 5

EP 0 661 804 B1

FIG. 6

# FIG. 7

EP 0 661 804 B1

FIG. 8

FIG. 9

FIG. 10

EP 0 661 804 B1

# FIG. 11

EP 0 661 804 B1